# EUROPEAN PATENT SPECIFICATION

(11) **EP 1 263 025 B1**
(45) Date of publication and mention of the grant of the patent: **20.10.2004**
(21) Application number: 01401416.1
(22) Date of filing: 31.05.2001
(51) Int. Cl.: H01L 21/00, H01J 37/32

(54) **Removable shield arrangement for plasma reactors**
Abnehmbare Schirmvorrichtung für Plasmareaktoren
Système de bouclier amovible pour des réacteurs à plasma

(43) Date of publication of application: 04.12.2002
(73) Proprietor: ALCATEL, 75008 Paris (FR)
(72) Inventor: Garabedian, Patrick, 91650 Breuillet (FR); Pagnod-Rossiaux, Philippe, 91180 St German les Arpajon (FR); Puech, Michel, 74370 Metz Tessy (FR)
(74) Representative: Lamoureux, Bernard

(56) References cited:
- EP-A- 0 673 056
- WO-A-01/01457
- US-A- 4 632 719
- US-A- 5 033 538
- US-A- 5 215 619
- US-A- 5 292 399
- US-A- 5 354 382
- US-A- 5 484 011
- US-A- 6 117 349

## Description

### OBJECT OF THE INVENTION

The present invention refers to ICP-RIE reactors (using etching by means of reactive ions with inductively coupled plasma sources) and to the etching procedures associated with them.

### STATE OF THE ART

A reactor of this type, which is currently used extensively in the manufacture of MEM=s, MOEM=s, advanced opto-electronics or micro-electronic devices, constitutes, in general terms, a system of dry etching Patterns as well as suited designs can be made on semi-conductive wafers, with sub-micron dimensions. Basically, a reactor of this kind is made up of an ICP plasma source, a plasma diffusion chamber and an RF-biased (13,56 MHz) substrate holder as in conventional RIE reactors.

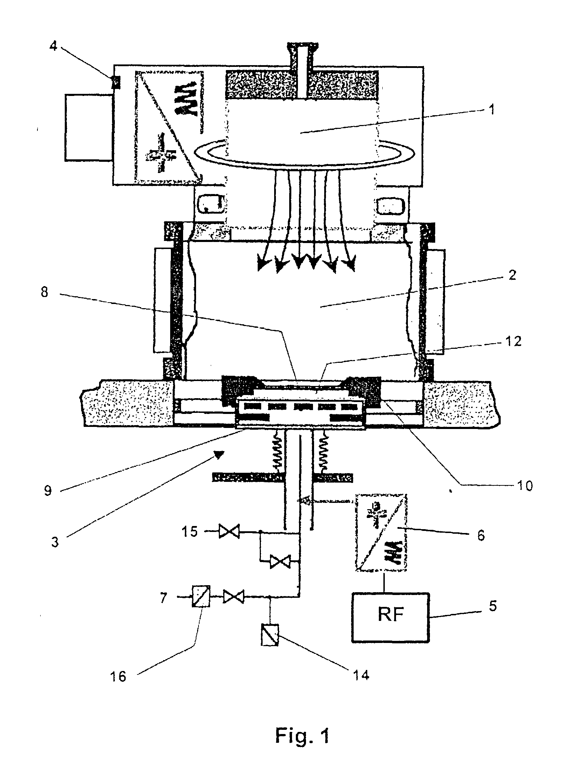

Figure 1 of the attached drawings diagrammatically illustrates a reactor of the kind to which the invention refers, in accordance with the known art, in which the plasma source is designated by 1, the diffusion chamber by 2 and, in a general way, the substrate holder by 3, being 5 a RF source generator. The plasma is generated in the source 1 from a process gas, for example SiCl₄ or Cl₂, which is pumped to said chamber, causing the process gas to be disassociated due to the impact of the electrons and Cl atoms that constitute the main etching agent.

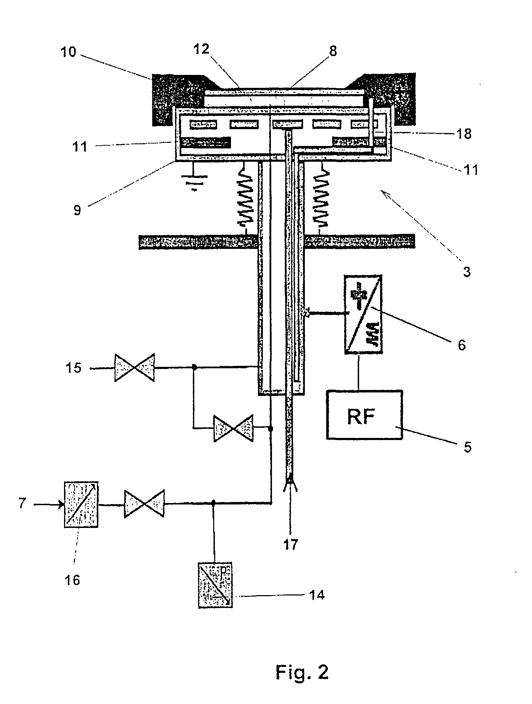

In most ICP-RIE reactors, said substrate holder 3 (illustrated in greater detail in Fig. 2) holds the substrate 8 to be etched in place by mechanical means on the chuck 9 of the substrate holder 3. Instead the substrate 8, the holder 3 can also hold a carrier wafers that can be used to handle small samples that cannot be directly mechanically clamped onto the substrate holder. The main function of said substrate holder 3 is to support the component 8, i.e. the substrate or the carrier wafers, during the etching process. Moreover, it must keep the substrate at a constant and accurate temperature and ensure its RF (13,56 MHz) bias, using an RF generator 5 connected to a match box unit 6, throughout the etching process.

The substrate is mechanically clamped and maintained on the chuck 9 of the substrate holder 3 under a large clamping ring 10 which is in the upper part of the substrate holder 3. This rugged mechanical part 10 is generally made of aluminum alloy or stainless steel, as are the other reaction chamber parts.

The chuck 9 may be cooled or heated respectively by means of a chiller or a liquid nitrogen circuit which enters through 17 (see fig. 2) and resistance heaters 11 installed inside the chuck 9. The temperature of the substrate holder 3 is then controlled by means of a regulation system (not shown) which balances the heating and cooling of the chuck 9.

The thermal exchange between the substrate 8 and the chuck 9 is ensured by means of a helium cushion 12 between the back of the substrate 8 and the chuck 9. The helium pressure, supplied under the substrate from a helium gas supply source 7, is maintained by a pump 15, using a helium conduit installed inside the substrate holder 3, the helium pressure being monitored by means of a manometer 14 and a mass flow controller 16.

During long etching processes, the function of this system for regulating the substrate temperature is to prevent thermal runaway of the substrate exposed to the extremely dense reactive plasma issuing from the ICP source.

ICP-RIE etching is used particularly in the field of etching applications on Si, SiO₂ or semiconductor materials of III-V groups, when an RF biasing is applied to the entire substrate holder. This means that both the substrate and the clamping ring must be RF biased.

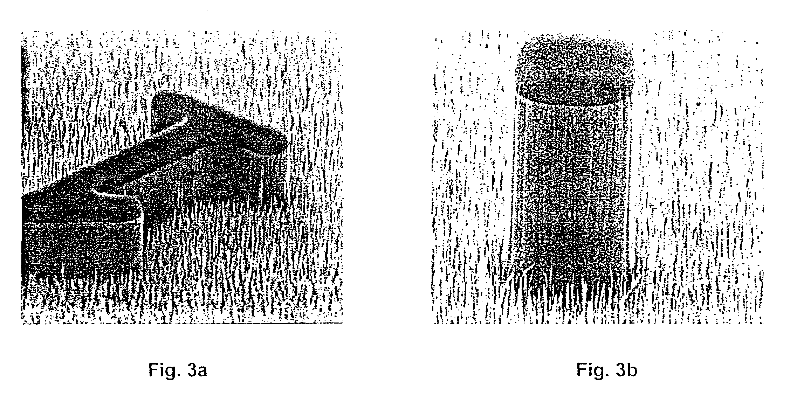

However, systems such as that just described, in accordance with the prior art, have different drawbacks:
i) A first drawback lies in the phenomena of parasitic etching and sputtering that occurs at the surface of the clamping ring 10. When applying the RF biasing to the substrate holder 3, the substrate 8 is RF biased, and so is the clamping ring 10. In this way the parasitic sputtering of the clamping ring 10 is very effective.
   With respect to the substrate 8, the role of this RF biasing is to improve the ion sputtering effect that takes place at the surface of the same. In this way, the relative energy (with respect to the substrate) of impinging ions emitted from the source is thus strongly increased. The higher the bias voltage of the substrate holder 3, the stronger the associated sputtering phenomenon on the substrate 8, as well as on the clamping ring 10. This biasing controls the anisotropy of the substrate etching.
   In known reactors of this class, the problem of the parasitic sputtering of the clamping ring is even more complicated when the reactive gas used to make the etching plasma is pure chlorine or a mixture of chlorinated gases. The chemical agents react with the aluminum alloy or stainless steel producing non-volatile by-products that drop upon the surface of the sample to form micro-masks. This micro-masking effect gives rise to rough-etched bottom surfaces of the substrate, as illustrated by the micro-photographs of figs. 3a and 3b. Also, in this case, these chemical reactions are strongly strengthened by the effect of ion sputtering. It must be pointed out that bulk aluminum (elemental aluminum) does not really lead to a micro-masking problem since aluminum-chloride (AlClₓ) by-products are volatile. The problems come from the other constituents of the aluminum alloy or its impurities.
   Due to the two components (chemical and mechanical) of the etching mechanisms that take place, the clamping ring 10 is etched and "consumed", creating a loading effect. This reduces the etch rate of the substrate sample by up to 30%. Moreover, when the aluminum clamping ring 10 is in a chlorine environment, it becomes gradually corroded, giving rise to corrosion spots which in turn constitute another source of micro-masking or surface pollution problems.
ii) Other problems come from the rise in temperature of the clamping ring 10, which starts as soon as the plasma has been ignited. The plasma is extremely dense and the ion current density at the surface of the substrate holder 3 is very high. Thus, a significant rise in temperature can be observed a few minutes after the beginning of the etching process, if this heating is not counterbalanced by the temperature regulation system (cooling).

Specifically, in all substrate holder sub-assemblies of various types of ICP-RIE reactors of the prior art, the substrate temperature is well regulated and controlled by means of the clamping system with helium back flow as described above. However, due to the mechanical design of these substrate holders 3, the temperature of the clamping ring itself 10 is not properly controlled (cooled) by the helium flow, as is the case, strictly speaking, with the substrate 8.

Thus, for long etching processes, especially at high ICP source powers, the heat is not evacuated from the clamping ring 10. Heat conduction taking place between the clamping ring 10 and the edge of the substrate 8 via the small surface where the substrate 8 is in close contact with the clamping ring 10, causes a non-homogeneous distribution of the temperature in the substrate 8. Thus, since the etching mechanisms are very sensitive to the substrate temperature, the etching results (depth, anisotropy, etc.) are not homogeneous all over the substrate 8.

Up to now, a solution known to the applicant for resolving the drawbacks in the prior art is the following.

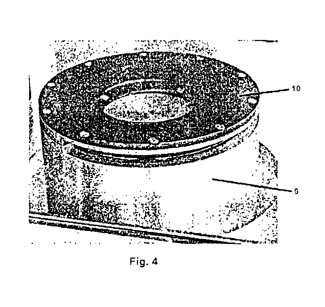

The aluminum clamping ring 10 can be passivated using a specific deposition process in order to make a thin layer of alumina covering the upper surface of the clamping ring 10. This Al₂O₃ film is chemically inert in the chlorine etching environment which is used, for example, for etching materials of the III-V groups. The photograph of fig. 4 shows (in perspective) a substrate holder of the commercially available Alcatel ICP-RIE 601 E system provided with a clamping ring 10 passivated by means of a specific treatment carried out by Pechiney for Alcatel Vacuum Technology France.

The passivation treatment suppresses the chemical reactions with chlorine compounds introduced into the reactor but, unfortunately, the thin layer of alumina is sputtered by energetic ions emitted from the ICP source and accelerated by the RF bias of the clamping ring. Finally as a consequence, the alumina film formed by passivation is completely removed from the surface of the ring 10, the total lifetime of such a treatment being very short. Moreover, the higher the bias voltage of the clamping ring 10, the shorter the lifetime of the passivation treatment.

US 5,292,399 discloses a reactor according to the preambule of claim 1. The top surface of the clamping ring and clamping fingers are covered with replaceable members in quartz or in conductive materials. Doped silicon is preferred as conductive material. There is no gap between the clamping ring or fingers and the covering replaceable members. The problem of the rise in temperature of the clamping ring is not disclosed.

On the other hand, as far as the applicant knows, no other solution has been proposed to resolve the problem of the rise in temperature of the clamping ring during a long etching process. In current practice, the only way to proceed is to interrupt the etching process for a few minutes. In this way, the clamping ring 10 is allowed to cool and then the etching process is resumed. This interruption must be repeated as many times as necessary until the depth set for etching is reached. However, such interruptions may give rise to significant degradation in the appearance and smoothness of the side walls formed by etching.

Other approach would be to use a water cooling circuit inside the substrate holder. It would be possible to cool the clamping ring 10 efficiently with a specific cooling circuit that would have to be held in close contact with the clamping ring. However, this approach is not simple and would make more difficult the realization of the substrate holder and consequently would also increase its total manufacturing cost.

The approach of passivating the clamping ring is not completely satisfactory. The passivation film is always thin (100 microns or less) and after several accumulated hours of operation this film is completely removed from the surface of the clamping ring 10 by ion sputtering. In other words, the lifetime of the passivated clamping ring 10 is still very short. Thus, the clamping ring 10 must be frequently replaced, increasing the machine down time. This point can be a serious drawback in production. As a result, the total manufacturing cost (including passivation treatment) of such a part is not negligible.

Another problem of this clamping ring 10 passivation treatment is related with chemical quality. If the passivation layer is not pure enough and contains certain impurities which have been incorporated during the deposition process (such as sulfur or metallic elements), non-volatile by-product formation and micro-masking problems will still exist. Of course, finding and monitoring the appropriate passivation treatment in terms of purity is extremely difficult and a guaranteed reproducible quality of the passivation treatment has not yet been achieved.
Therefore, this approach does not resolve the problem of clamping ring 10 thermal runaway that can occur during a long etching process.

### CHARACTERISATION OF THE INVENTION

Therefore, the object of the present invention is to provide an effective shield in ICP-RIE reactors against parasitic sputtering and excessive heating of the clamping ring of the substrate holder, which is more appropriate for long or chlorine-based etching processes in reactors which use plasma.

In order to do this, the invention refers to a reactor for applying etching to a substrate using reactive ions, comprising a plasma source, a diffusion chamber and a substrate holder, with clamping ring means provided in said substrate holder to hold a substrate that is to be exposed to a reactive ion flow from said plasma, including a shield arrangement fixed in a detachable way to said substrate holder, above said clamping ring means, for masking said clamping ring means against said reactive ion flow.

The invention is described according to claim 1. The preferred embodiments of the invention are described by the dependent claims.

In accordance with the invention, said shield arrangement is mounted on said substrate holder above said clamping ring means and separated by a small distance from said clamping ring means, and is made of a metallic material.

In accordance with an embodiment, said shield arrangement is made up of at least two very thin rings stacked above said clamping ring means, separated from each other and from said clamping ring means.

In accordance with a possible embodiment, the material of said shield arrangement is passivated by covering with a very thin film of a dielectric material.

In accordance with a preferred embodiment of the invention, said shield arrangement is electrically connected to ground through the substrate holder.

### BRIEF DESCRIPTION OF THE DRAWINGS

Two preferred embodiments of the invention are described below, exclusively by way of example and with reference to the attached drawings, in which:
Fig. 1 is a diagrammatic representation of a known ICP-RIE reactor, in accordance with the prior art;
Fig. 2 is an enlarged diagrammatic view of the substrate holder of the reactor of fig. 1, in accordance with the prior art;
Figs. 3a and 3b are two micro-photographs showing bottom surfaces of a substrate which have undergone rough-etching due to micro-masking problems;
Fig. 4 shows the arrangement of a passivated masking ring in a substrate holder of a reactor of the class to which the invention refers;
Fig. 5 is a similar view to that of fig. 2, illustrating a substrate holder which incorporates an embodiment of the present invention; and
Fig. 6 is a similar view to that of fig. 5, illustrating a substrate holder which incorporates an additional embodiment of the present invention.

### DESCRIPTION OF THE INVENTION

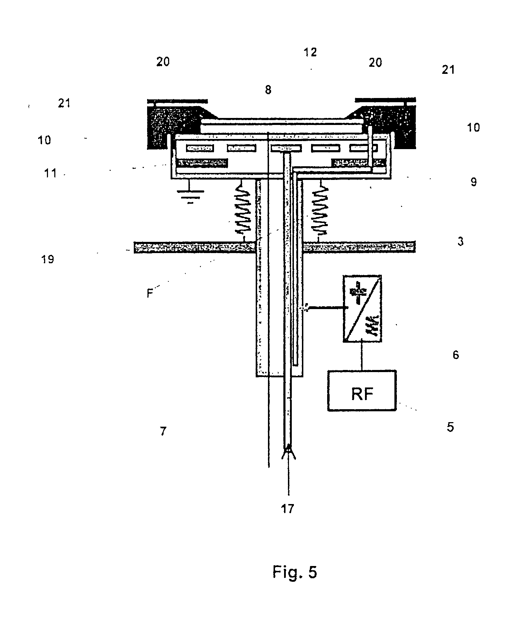

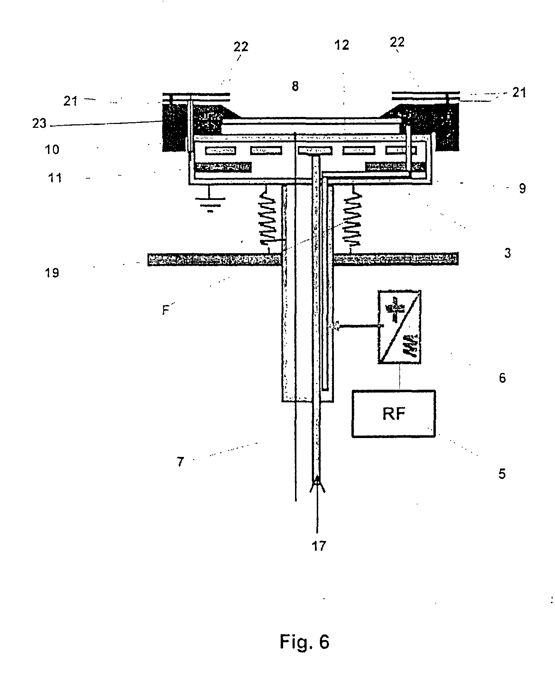

The solution proposed by the present invention (see figs. 5 and 6) is based on the use of a shield 20, mounted just above the chuck 9 of the substrate holder 3, which is fitted to the etching chamber by means of a mechanical flange 19 that allows said substrate holder 3 to be coupled to the etching chamber (not shown) in order to guarantee the etching reactor to be leak tight or to guarantee vacuum integrity within the etching reactor. F indicates, diagrammatically, a bellows to allow vertical movement of said substrate holder 3, in order to adjust the distance between the ICP source and the substrate 8 inside the reactor 1. Said flange 19 and said spring 8 are electrically connected to ground.

Said shield 20 protects the clamping ring 10 against the ion flux from the ICP source. This shield 20 must prevent the clamping ring 10 from undergoing mechanical erosion but, at the same time, it must act as a thermal shield.

In order to provide protection for said clamping ring 10, the shield 20 is mounted separately at a small pre-determined distance, of a few tenths of mm, above the clamping ring 10 by means of a spacer 21 provided close to its periphery, so that a space is defined in which there is a vacuum between the shield 20, heated by the ion flux, and the clamping ring 10. In this way, effective thermal protection is achieved, which prevents any temperature rise of the clamping ring 10.

In accordance with another preferred embodiment of the present invention, represented in fig. 6, the protective shield is made up of at least two (for example, 2 or 3) very thin rings 22 made of aluminum, tungsten or tantalum, physically separated from each other and from the clamping ring 10 by a small pre-determined distance of a few tenths of mm, by means of spacers 21 arranged near the periphery of said shield. Also, in this case, the vacuum gap between the clamping ring 10 and the rings 22 which constitute the shield and between the rings 22 themselves, provides an effective thermal insulation of the clamping ring 10.

Being metallic, these shields 20, 22 in accordance with the invention, may be electrically connected to ground at 23, through the substrate holder 9, so the metallic shields are not biased and thus the relative energy of the impinging ions with respect to the shield is extremely low (plasma potential is approximately a few eV (10≈15V) only while the RF-biased clamping ring potential is in the 100-400V range) thus strongly reducing, or even suppressing, the effects of the parasitic sputtering mechanisms.

The tungsten and the tantalum, which are proposed as preferred metals for manufacturing the metallic shields 20 and 22 are not affected by the chlorine environment (they are not chemically attacked by the chlorine) but in any case and in accordance with yet another preferred embodiment of the invention, these metals can be passivated to provide them with a very thin dielectric film (it can be very thin since parasitic sputtering effects no longer exist) of SiNₓ or Al₂O₃ simply deposited by a conventionally PECVD technique (Plasma Enhanced Chemical Vapor Deposition). Aluminum may also be used, but then it is safer, with respect to chlorinated chemical agents, to cover the part with a PECVD dielectric film.

Although the invention has been described with respect to several preferred embodiments, it will be understood that these have been given solely by way of example and that many other variations, modifications and applications of the invention may be carried out.

## Claims

1. A reactor for applying etching to a substrate by means of reactive ions, comprising a plasma source (1), a diffusion chamber (2) and a substrate holder (3), with clamping ring means (10) provided in said substrate holder (3) to hold in place a substrate (8) that is to be exposed to a reactive ion flux from said plasma, including a separate shield arrangement (20) which is fixed in a detachable way on said substrate holder (3) above said clamping ring means (10), and which is intended to mask said clamping ring means (10) against said reactive ion flux, **characterised in that** said shield arrangement (20), mounted on said substrate holder (3) above said clamping ring means (10), is separated by a small distance above said clamping ring means (10), so that a space is defined in which there is a vacuum between the shield arrangement (20), heated by the ion flux, and the clamping ring (10).

2. A reactor according to claim 1, **characterised in that** said shield arrangement (20) is mounted on said substrate holder (3) at a distance of approximately a few tenths of a millimetre above said clamping ring (10).

3. A reactor according to claims 1 or 2, **characterised in that** said shield arrangement (20) is made up of a single ring with similar transverse dimensions to those of said clamping ring means (10).

4. A reactor according to claims 1 or 2, **characterised in that** said shield arrangement(20) is made up of at least two very thin rings which are stacked, with a small mutual separation, above said clamping ring means (10).

5. A reactor according to any claims 1 to 4, **characterised in that** said shield arrangement (20) is made of a metallic material offering good mechanical rigidity which at the same time protects said clamping ring means (10) against mechanical erosion caused by ion sputtering.

6. A reactor according to claim 5, **characterised in that** said metallic material is selected from the group of aluminium, tungsten, tantalum or compounds of the same.

7. A reactor according to any claims 1 to 6, **characterised in that** the metallic material of said shield arrangement (20) has been passivated by means of covering with a very thin film of dielectric material.

8. A reactor according to any claims 1 to 7, **characterised in that** said shield arrangement (20) is electrically connected to ground through said substrate holder (3).

9. A reactor according to any claims 1 to 8, **characterised in that** said shield arrangement (20) is mounted a said small pre-determined distance above said clamping ring (10) by means of a spacer (21).

10. A reactor according to claim 9, **characterised in that** said spacer (21) is provided close to the periphery of said clamping ring (10).

## Patentansprüche

1. Ein Reaktor zum Ätzen eines Substrates mittels reaktiver Ionen, der aus einer Plasmaquelle (1), einer Diffusionskammer (2) und einem Substrathalter (3) mit Klemmring-Mitteln (10), die in dem Substrathalter (3) bereitgestellt werden, um ein Substrat (8) festzuhalten, das einem reaktiven Ionenfluss von dem Plasma ausgesetzt wird, besteht und der eine getrennte Schirmvorrichtung (20) enthält, die abnehmbar auf dem Substrathalter (3) über den Klemmring-Mitteln (10) befestigt ist und welche die Klemmring-Mittel (10) gegen den Fluss reaktiver Ionen abschirmt, **dadurch gekennzeichnet, dass** die auf dem Substrathalter (3) über den Klemmring-Mitteln (10) montierte Schirmvorrichtung (20) sich einen geringen Abstand über den Klemmring-Mitteln (10) befindet, so dass ein Abstand festgelegt ist, in dem ein Vakuum zwischen der Schirmvorrichtung (20), die durch den Ionenfluss aufgeheizt wird, und dem Klemmring (10) vorliegt.

2. Ein Reaktor gemäß Anspruch 1, **dadurch gekennzeichnet, dass** die Schirmvorrichtung (20) auf dem Substrathalter (3) in einer Entfernung von ungefähr einigen Zehntel Millimeter über dem Klemmring (10) montiert ist.

3. Ein Reaktor gemäß Anspruch 1 oder 2, **dadurch gekennzeichnet, dass** die Schirmvorrichtung (20) aus einem einzigen Ring hergestellt ist, der die gleichen Diagonal-Abmessungen wie die Klemmring-Mittel (10) hat.

4. Ein Reaktor gemäß Anspruch 1 oder 2, **dadurch gekennzeichnet, dass** die Schirmvorrichtung (20) aus mindestens zwei sehr dünnen Ringen hergestellt ist, die mit einem kleinen Abstand zueinander über den Klemmring-Mitteln (10) aufgesetzt sind.

5. Ein Reaktor gemäß einem beliebigen der Ansprüche 1 bis 4, **dadurch gekennzeichnet, dass** die Schirmvorrichtung (20) aus einem metallischen Material hergestellt ist, das eine gute mechanische Festigkeit bietet und das gleichzeitig die Klemmring-Mittel (10) gegen durch Ionen-Sputtern verursachte mechanische Erosion schützt.

6. Ein Reaktor gemäß Anspruch 5, **dadurch gekennzeichnet, dass** das metallische Material aus der Gruppe Aluminium, Wolfram, Tantal oder Verbindungen derselben ausgewählt wird.

7. Ein Reaktor gemäß einem beliebigen der Ansprüche 1 bis 6, **dadurch gekennzeichnet, dass** das metallische Material der Schirmvorrichtung (20) durch Abdeckung mit einer sehr dünnen Schicht eines dielektrischen Materials passiviert wurde.

8. Ein Reaktor gemäß einem beliebigen der Ansprüche 1 bis 7, **dadurch gekennzeichnet, dass** die Schirmvorrichtung (20) über den Substrathalter (3) elektrisch mit Erde verbunden ist.

9. Ein Reaktor gemäß einem beliebigen der Ansprüche 1 bis 8, **dadurch gekennzeichnet, dass** die Schirmvorrichtung (20) mit einem Abstandshalter (21) eine kleine vorher festgelegte Entfernung über dem Klemmring (10) montiert ist.

10. Ein Reaktor gemäß Anspruch 9, **dadurch gekennzeichnet, dass** der Abstandshalter (21) in der Nähe des Außenrandes des Klemmringes (10) bereitgestellt wird.

## Revendications

1. Réacteur servant à attaquer un substrat à l'aide d'ions réactifs, comprenant une source de plasma (1), une chambre de diffusion (2) et un porte-substrat (3), un moyen formant anneau de serrage (10) étant prévu dans ledit porte-substrat (3) pour maintenir en place un substrat (8) appelé à être exposé à un flux d'ions réactifs provenant dudit plasma, comportant un système de bouclier distinct (20) fixé de manière détachable sur ledit porte-substrat (3), au-dessus dudit moyen formant anneau de serrage (10), et qui est destiné à masquer ledit moyen formant anneau de serrage (10) vis-à-vis dudit flux d'ions réactifs, **caractérisé en ce que** ledit système de bouclier (20), monté sur ledit porte-substrat (3) au-dessus dudit moyen formant anneau de serrage (10) est séparé d'une petite distance au-dessus dudit moyen formant anneau de serrage (10), de façon à définir un espace dans lequel un vide est formé entre le système de bouclier (20), chauffé par le flux d'ions, et l'anneau de serrage (10).

2. Réacteur selon la revendication 1, **caractérisé en ce que** ledit système de bouclier (20) est monté sur ledit porte-substrat (3) à une distance de quelques dizaines de millimètre, environ, au-dessus dudit anneau de serrage (10).

3. Réacteur selon les revendications 1 ou 2, **caractérisé en ce que** ledit système de bouclier (20) est constitué d'un seul anneau dont les dimensions transversales sont similaires à celles dudit moyen formant anneau de serrage (10).

4. Réacteur selon les revendications 1 ou 2, **caractérisé en ce que** ledit système de bouclier (20) est constitué d'au moins deux anneaux très minces qui sont empilés, avec une petite séparation mutuelle, au-dessus dudit moyen formant anneau de serrage (10).

5. Réacteur selon l'une quelconque des revendications 1 à 4, **caractérisé en ce que** ledit système de bouclier (20) est constitué d'une matière métallique offrant une bonne rigidité mécanique qui protège en même temps ledit moyen formant anneau de serrage (10) de l'érosion mécanique causée par la pulvérisation des ions.

6. Réacteur selon la revendication 5, **caractérisé en ce que** ladite matière métallique est choisie dans le groupe comprenant l'aluminium, le tungstène, le tantale ou des composés de ceux-ci.

7. Réacteur selon l'une quelconque des revendications 1 à 6, **caractérisé en ce que** la matière métallique dudit système de bouclier (20) a été passivée en étant recouverte d'une pellicule très mince de matière diélectrique.

8. Réacteur selon l'une quelconque des revendications 1 à 7, **caractérisé en ce que** ledit système de bouclier (20) est raccordé électriquement à la masse par l'intermédiaire dudit porte-substrat (3).

9. Réacteur selon l'une quelconque des revendications 1 à 8, **caractérisé en ce que** ledit système de bouclier (20) est monté à ladite petite distance prédéterminée au-dessus dudit anneau de serrage (10) au moyen d'un élément d'écartement (21).

10. Réacteur selon la revendication 9, **caractérisé en ce que** ledit élément d'écartement (21) est prévu à proximité de la périphérie dudit anneau de serrage (10).
